# FASCICULE DE BREVET EUROPEEN

(11) **EP 2 232 963 B1**
(45) Date de publication et mention de la délivrance du brevet: **19.09.2018**
(21) Numéro de dépôt: 08862375.6
(22) Date de dépôt: 04.12.2008
(51) Int. Cl.: H05K 1/00, H01Q 1/27, H05K 1/03, H05K 3/32, H05K 3/34, H05K 3/40, G06K 19/02, G06K 19/077, H05K 3/10, H01Q 1/22

(54) **PROCÉDÉ DE RÉALISATION D'UN DISPOSITIF COMPORTANT AU MOINS DEUX COMPOSANTS DISTINCTS INTERCONNECTÉS PAR DES FILS D'INTERCONNEXION ET DISPOSITIF OBTENU**
VERFAHREN ZUR HERSTELLUNG EINER VORRICHTUNG, DIE MINDESTENS ZWEI VERSCHIEDENE KOMPONENTEN UMFASST, DIE DURCH VERBINDUNGSDRÄHTE MITEINANDER VERBUNDEN SIND, UND SO ERHALTENE VORRICHTUNG
METHOD OF PRODUCING A DEVICE INCLUDING AT LEAST TWO DISTINCT COMPONENTS INTERCONNECTED BY INTERCONNECTION WIRES AND DEVICE OBTAINED

(30) Priorité: 13.12.2007 EP 07301673
(43) Date de publication de la demande: 29.09.2010
(73) Titulaire: Gemalto SA, 92190 Meudon (FR)
(72) Inventeur: SEBAN, Frédérick, 13260 Cassis (FR); FIDALGO, Jean-Christophe, 13420 Gemenos (FR)
(74) Mandataire: Milharo, Emilien
(86) Numéro de dépôt international: PCT/EP2008/066829
(87) Numéro de publication internationale: WO 2009/077347

(56) Documents cités:
- DE-A1- 4 138 131
- FR-A- 2 833 109
- JP-A- 2002 298 110
- US-A- 6 088 230
- US-A1- 2006 254 811
- US-A1- 2006 289 469

## Description

L'invention concerne le domaine des procédés d'interconnexion de composants.

En particulier, elle concerne un procédé de réalisation d'un dispositif comportant au moins deux composants distincts interconnectés sur un substrat par des fils d'interconnexion et le dispositif obtenu

L'invention concerne principalement la fabrication d'objets intelligents de type multi-composants se présentant sous toute forme, comme par exemple des cartes à circuit(s) intégré(s), des passeports, des inserts électroniques de faible épaisseur.

Elle a pour objectif de permettre une fabrication économique, simple d'objets multi-composants qui présentent de préférence de bonnes propriétés de résistance mécanique notamment à la flexion.

Les cartes multi composants actuelles notamment des cartes avec batterie, microcontrôleur, afficheur, nécessitent de réaliser un insert comportant des pistes d'interconnexion gravées sous forme de circuit imprimé. Les composants sont ensuite reportés et connectés par soudure ou par colle conductrice le cas échéant. Le support a l'inconvénient d'être plutôt rigide et le procédé plutôt onéreux.

En outre, des composants à connecter de type SMD tels des capteurs biométriques, sont assez fragiles et ne supportent pas des procédés bien connus de connexion par thermo compression d'un fil sur des plages de contact, une sonde appuyant et apportant de l'énergie thermique directement sur le fil.

La demande de brevet US2006/0254811 décrit un circuit électrique réalisé à partir d'un tissu dont des fils de chaîne et de trame comprennent des fils conducteurs. Il est nécessaire de souder les fils de chaîne et trame entre eux pour changer de direction.

L'invention vise notamment à résoudre les inconvénients précités.

L'invention propose également une solution économique et industrielle d'interconnexion de composants ou de réalisation de circuits électroniques comportant des composants interconnectés.

A cet effet, l'invention a pour objet un procédé de réalisation d'un dispositif comportant au moins deux composants distincts interconnectés sur un substrat par au moins un fil d'interconnexion. Le procédé se distingue en ce qu'il comprend les étapes suivantes :
- réalisation du fil d'interconnexion (3) par dépôt de fil individuel sur le substrat (2, 2f, 2b) selon un motif d'interconnexion prédéfini, ledit fil comportant au moins une portion terminale (7, 8) de connexion exposée sur le substrat,
- report d'au moins un contact d'un composant en regard de la portion terminale et connexion du contact à cette portion terminale.

Selon d'autres caractéristiques préférées visant à permettre la connexion de composants fragiles:
- la portion terminale étant gainée d'isolant, le procédé comporte une étape de mise à nu préalablement ou au cours de la connexion;
- la mise à nu s'effectue par un aplatissement de la portion terminale préalablement à la connexion;
- la connexion est réalisée par un adhésif conducteur (G) apporté entre la portion terminale et le contact;

Outre la résolution des inconvénients précités, l'invention permet une souplesse de fabrication du dispositif par un découplage de la fabrication des pistes d'interconnexion des autres opérations classiques de réalisation d'insert, notamment le report préalable des plages de contact ou composant sur un substrat, réalisation préalable d'une cavité sous les portions à connecter, enrobage des connexions.

Selon d'autres caractéristiques de mise en oeuvre:
- le fil d'interconnexion est réalisé par broderie ou couture sur un substrat souple comportant un tissu et en ce qu'il comprend une étape selon laquelle on dispose un matériau de renfort sous forme de feuille ou couche sur une face du substrat opposée à celle portant les portions terminales;
- le fil d'interconnexion est un fil hybride (22) associé à au moins un fil non conducteur;
- la couche ou feuille de renfort est disposée après réalisation du fil d'interconnexion;
- le procédé comprend une étape de formation d'une cavité dans le substrat et/ou feuille ou couche de renfort à proximité des portions terminales;

L'invention a également pour objet un dispositif comportant au moins deux composants distincts sur un substrat et interconnectés par au moins une piste d'interconnexion,
Le dispositif se distingue en ce que la piste est réalisée par technique filaire sur le substrat, ladite piste comportant au moins une portion terminale de connexion exposée sur le substrat,
- au moins un contact électrique d'un composant étant reporté en regard de la portion terminale et connecté à cette portion terminale.

Selon d'autres caractéristiques du dispositif:
- le fil étant gainé d'isolant, la portion terminale est mise à nu au niveau de la connexion;
- la portion terminale comporte un aplatissement au niveau de la connexion;
- la connexion est réalisée par un adhésif conducteur (G) apporté entre la portion terminale et le contact;
- la piste ou fil est réalisée par broderie ou couture sur un support ou substrat souple comportant un tissu et un matériau de renfort sous forme de feuille ou couche est disposé sur une face du substrat opposée à celle portant les portions terminales,
- une cavité est disposée dans le substrat et/ou feuille ou couche de renfort à proximité des portions terminales;
- le fil d'interconnexion est un fil hybride associé à au moins un fil non conducteur.

L'invention a également pour objet un produit électronique multi-composants, tel une carte à puce, passeport, comprenant le dispositif ci-dessus ou obtenu selon le procédé ci-dessus.

D'autres particularités et avantages de l'invention apparaîtront à la lecture de la description, qui suit, donnée à titre d'exemple illustratif et non limitatif, et faite en référence aux figures annexées pour lesquelles :
- la figure 1 illustre une vue schématique d'un dispositif pouvant être obtenu selon un mode de mise en oeuvre du procédé de l'invention ;
- la figure 2 illustre une première étape de réalisation de fils d'interconnexion selon un mode de mise en oeuvre du procédé de l'invention ;
- la figure 3 illustre une vue schématique se différents modes de réalisation de fils d'interconnexion sur un substrat selon l'invention;
- la figure 4 illustre une vue en coupe d'un second mode de réalisation, le fil d'interconnexion étant réalisé en fil incrusté;
- la figure 5 illustre une vue en coupe d'un troisième mode de réalisation et dans lequel la tenue du substrat est renforcé avec une feuille, le fil d'interconnexion étant brodé sur un tissu;
- la figure 6 illustre une vue en coupe d'un quatrième mode de réalisation montrant une connexion avec un fil d'antenne brodé;
- la figure 7 illustre une vue en coupe d'un cinquième mode de réalisation montrant une connexion avec un fil d'antenne hybride;
- les figures 8 et 9 illustrent une autre configuration des plages en regard du fil d'antenne et leur connexion;
- la figure 10 illustre un support tissé portant un fil d'antenne fixé par fil de broderie;
- la figure 11 illustre les étapes du procédé selon des modes préférés de mise en oeuvre;
- la figure 12 illustre un autre mode de réalisation du dispositif et interconnexion avec fils nus;
- les figures 13 à 16 illustrent un autre mode préféré de réalisation du dispositif et d'interconnexion avec fils aplatis;

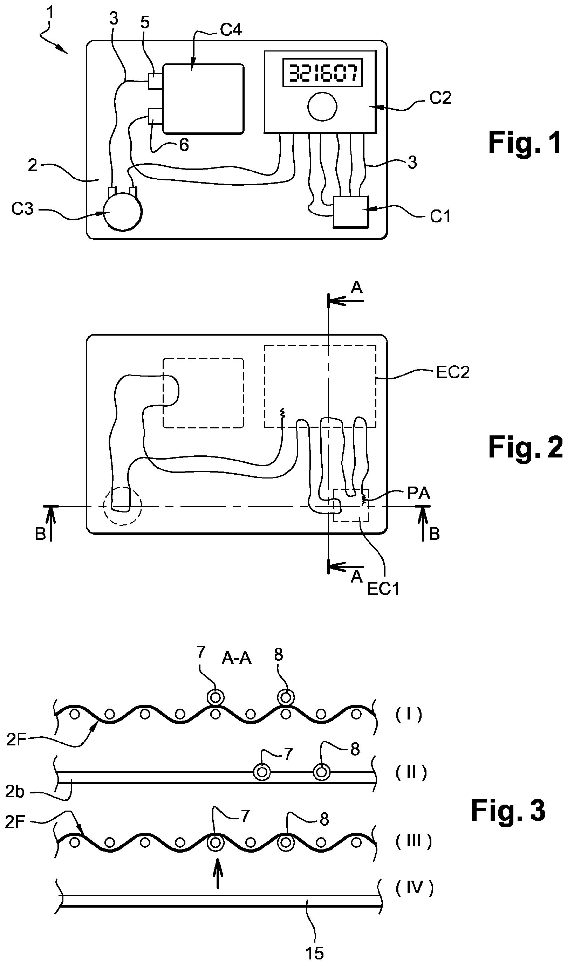

La figure 1 illustre un dispositif comportant au moins deux composants distincts C1, C2 sur un substrat et interconnectés par au moins une piste d'interconnexion 3, réalisé conformément à un mode de mise en oeuvre de l'invention.

Il s'agit ici d'un dispositif multi composants comportant, un capteur biométrique C1, un générateur C2 d'OTP (numéro d'accès à usage unique) avec microcontrôleur, un interrupteur C3, une batterie C5.

Par composant, on entend tout élément de circuit électrique ou électronique, électromécanique. Un simple contact isolé peut aussi être considéré, dans certains cas comme un composant électrique de liaison.

Conformément à un mode de réalisation, à la figure 2, les pistes ou fils d'interconnexion conducteurs (3) sont réalisés par technique filaire sur le substrat, ici la broderie. Les techniques filaires au sens de l'invention comprennent les techniques de dépôt ou report de matériau conducteur longiligne individuel sur un substrat tel que la broderie, la couture, le tricot, mais aussi du fil déposé par incrustation notamment par ultrason ou collé sur un substrat. Le fil peut avec une section quelconque, notamment pour du fil plat une section parallélépipédique. Le fil est continu et homogène entre ses points de connexion.

Par opposition, les pistes obtenues par élimination de métal : gravure, découpe de feuille métallique ne font pas partie des techniques filaires.

Le fil est de préférence apporté sur un substrat selon un motif d'interconnexion distinct ou indépendant de la structure du substrat. Le fil d'interconnexion est apporté de manière continue en un même fil sans soudure ou changement de fil entre deux zones destinées à recevoir des points de connexion.

De préférence, le substrat ne comporte pas encore les composants ou plages à connecter. Toutefois, l'invention peut prévoir d'avoir des composants ou plages ou pistes déjà sur le substrat avant le report du fil.

Ainsi par exemple, des points de connexion placés sur des fils de chaine et de trame distincts d'un tissu peuvent être connectés directement par un seul fil droit ou présentant des courbes.

Le fil d'interconnexion 3 comporte au moins une portion qui est destinée à la connexion exposée sur ou dans le substrat (selon un autre mode ci-dessous); Après broderie, ces portions reposent sur le substrat et sont donc exposées à des composants pour connexion.

Les fils s'étendent de préférence au delà du point prévu de connexion à l'intérieur de zones (EC1, EC2..) correspondant à l'emplacement de composants (en pointillé).

Selon un mode de mise en oeuvre préféré, de façon à optimiser la cadence de l'étape de report ou de réalisation des fils d'interconnexion sur le support, on évite toute discontinuité au cours de la réalisation d'une multitude de fils d'interconnexion. Ainsi, le motif dessiné par le fil sera non seulement continu entre les zones (EC1, EC2...) d'emplacement des composants mais de préférence également à l'intérieur des zones.

Ainsi par exemple, le fil 3 forme des boucles continues BC s'étendant à l'intérieur des emplacements EC1, EC2.... Le point de départ PD du fil se trouve dans la zone EC2 et le point d'arrivé PA dans EC1 ou vice versa. Cependant, on peut aussi avoir un point de départ dans une zone et un point d'arrivé PA dans une autre pour chaque fil d'interconnexion.

Le cas échéant, on peut même avoir une continuité de fil entre une multitude de motifs continus, chaque motif étant destiné à former des interconnexions pour chaque dispositif. La continuité correspond notamment à des motifs réalisés par une même tête de broderie ou couture ou incrustation. Cela évite notamment d'avoir à effectuer des points d'arrêt de fil de broderie aux extrémités de chaque fil d'interconnexion ou d'avoir à couper le fil, survoler une zone, arrêter les ultrasons, les remettre en technique d'incrustation de fil.

Les découpes des zones de réception de composant ou au moins une partie supportant une portion de fil assureront le "décourt-circuitage" ou mise hors court-circuit des fils d'interconnexion.

Le cas échéant, le support peut comporter des portions de fil s'étendant entre emplacements ou dans des emplacements juste pour assurer une continuité du motif; ces portions peuvent ne pas être connectées ultérieurement.

En résumé, on réalise un motif ayant un fil continu destiné à former au moins deux fils d'interconnexion continus après sa découpe. On découpe le motif, dans une étape ultérieure, pour former au moins les deux fils d'interconnexion et mettre ces deux fils hors court-circuit.

La découpe s'effectue de préférence après qu'un matériau de renfort ait été fixé sur le support en enlevant également par découpe le support avec le matériau de renfort et une portion de fil. Le renfort facilite la manipulation, le positionnement et la découpe.

Trois modes de réalisation du support avec fils d'interconnexion sont illustrés à la figure 3. Le premier (I) comporte un substrat en tissu, les fils d'interconnexion étant brodés; Le second (II) comporte un substrat en plastique ou papier, les fils étant réalisés en fils incrustés ou déposés par ultrasons; Le troisième (III) (qui n'est pas en correspondance avec la figure 2) comporte un substrat tissé, les fils d'interconnexion étant dans le tissu comme fil de chaine et/ou trame; les fils peuvent être aussi préalablement fixés à des endroits prédéterminés sur un substrat.

De préférence, un matériau de renfort ou stabilisant 15 est laminé, fixé contre les substrats en tissu (I, III).

Sur le dispositif, au moins un contact (5, 6) d'un des composants est reporté en regard de chaque portion terminale (7, 8, 7b, 8b) et est connecté à cette portion terminale selon différents procédés comme expliqué par la suite.

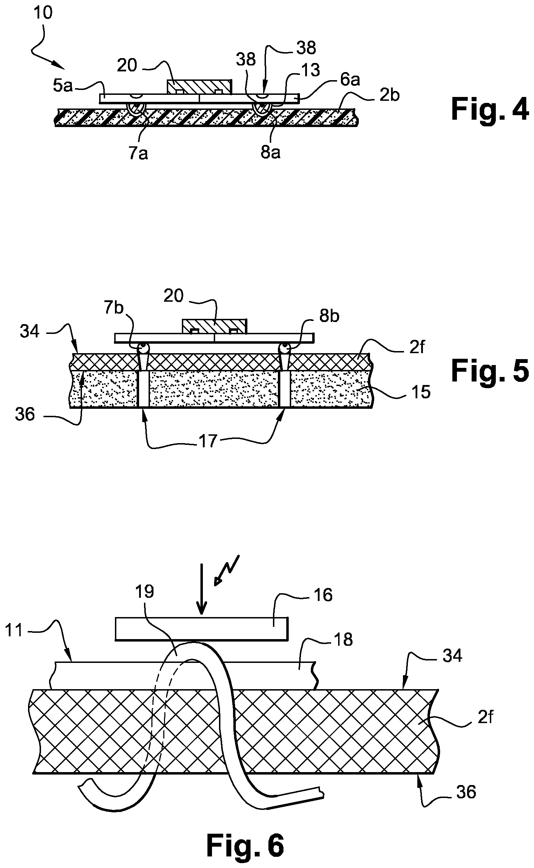

La figure 4 illustre une vue schématique d'un autre dispositif 10 comportant au moins un fil d'interconnexion 7a, 8b connecté à des plages de contact 5a, 6a sur un substrat 2b et pouvant être obtenu selon un autre mode de mise en oeuvre du procédé de l'invention. Il s'agit ici d'un module portant une puce de circuit intégré 20 comme composant.

Le composant 20 est reporté sur les fils d'interconnexion reposant sur le substrat. Il s'agit ici de fils réalisés par incrustation de fil conducteur sur une feuille polymère 2b. Le fil conducteur peut être enrobé d'un vernis ou gaine isolante 13.

Contrairement à l'art antérieur où le fil est connecté en étant disposé sur une plage de contact d'un composant déjà en place, le fil étant disposé entre la plage et un outil de thermo-compression, dans l'invention, on dispose d'abord la portion terminale de connexion 8a sur le substrat puis on reporte la plage de contact 6a dessus et on apporte l'énergie de soudure, notamment par thermo compression, à travers la plage de contact en y laissant une marque 38 correspondante . Cela a notamment l'avantage d'avoir une surface de soudure toujours propre pour l'outil de soudure.

A la figure 5, toujours avec la même configuration de report, l'antenne est réalisée par broderie ou couture sur un support souple comportant un tissu 2f. Le support est souple dans la mesure où il n'a pas de tenue, de rigidité comme tous les tissus fins. Le maillage (m) lâche entre des fils de chaine et trame est par exemple compris entre 200 µm et 300 µm dans les deux sens) avec un fil en polyamide de 80pm d'épaisseur ou de 48dtex. En outre, le tissu 2f n'est pas stable dimensionnellement dans la mesure où il peut s'étirer normalement à la main notamment en diagonale par exemple au moins de 3 % à 20 %. Cette élongation peut être inférieure à 1 % dans le sens du défilement du substrat sens chaine ou trame sous une tension de défilement en production.

Le maniement du tissu support d'une antenne brodée étant très délicat (matériau tissé souple et ouvert entre les mailles), il est prévu de le stabiliser avec un matériau de renfort 15, sous forme de feuille ou couche, disposée sur une face du substrat opposée à celle portant les portions terminales de l'antenne; On procède à la fixation d'un matériau stabilisant 15 par adjonction d'une feuille de type PVC, PET, Polycarbonate, de type Teslin ou papier.

De préférence, l'adjonction de la feuille de renfort est effectuée après la réalisation de l'antenne ou piste conductrice de manière à ne pas gêner les cadences de production. Mais pourrait être réalisée avant, le cas échéant avec des rendements moins intéressants et risques d'endommagement des aiguilles du métier à broder ou à coudre etc...

Un effet semblable à l'ajout d'une feuille peut être obtenu par imprégnation ou enduction d'une couche ou pulvérisation d'un produit tel un enduit, un apprêt, une résine, une mousse polymère, une gomme, apte à stabiliser dimensionnellement le substrat.

L'assemblage peut être réalisé par lamination, soudure thermique (fusion des matériaux) ou addition d'un adhésif (en film, liquide). Le substrat étant très fin pour des questions de productivité et facilité de mise en oeuvre.

Cette étape permet également de conférer plus d'épaisseur au substrat pour permettre une réception d'une partie au moins d'un composant dans le support lors du report de ce dernier.

Le dispositif comporte des perforations 17, éventuellement refermées en partie, dans le matériau de renfort en regard de chaque connexion et portion terminale 7b, 8b, connectée ainsi qu'il résulte de l'utilisation d'une enclume très fine ou aiguille appliquée sous le fil conducteur à connecter et qui perfore le matériau comme expliqué ultérieurement.

A la figure 6 une plage de contact seule 16, non encore connectée à un microcircuit ou composant est reportée sur une portion terminale de fil d'interconnexion 18 brodé avec un fil de broderie 19 pour la fixation du fil d'interconnexion sur le support fibreux 2f. La connexion à un microcircuit 20 à la plage 16 pourra s'effectuer ultérieurement par tout moyen connu, notamment par puce retournée (flip-chip) et colle conductrice

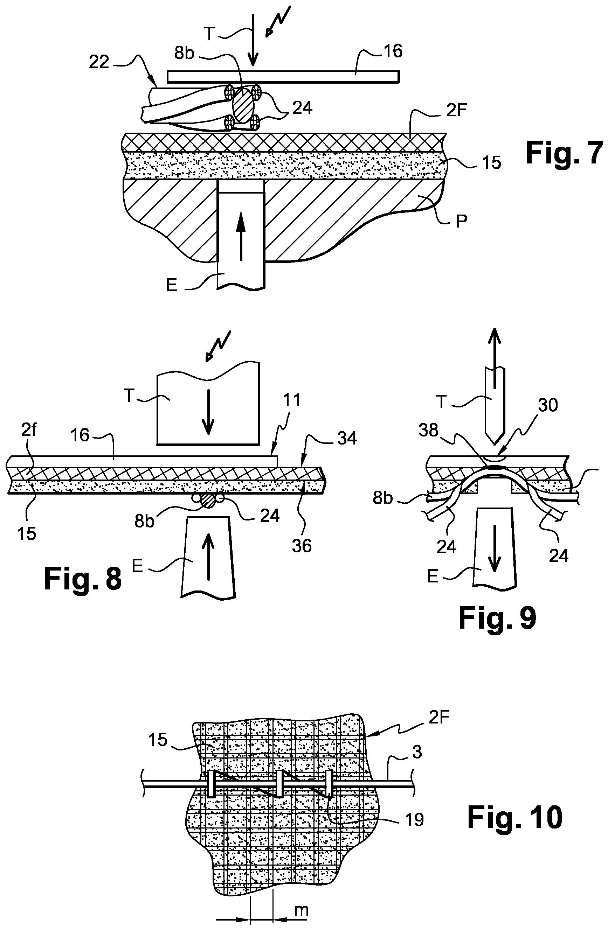

A la figure 7, un autre mode de réalisation le dispositif comporte une connexion avec un fil d'interconnexion hybride 22 dans la mesure où le fil 3 est associé à quatre fils non conducteurs 24; l'association peut cependant compter au moins un fil non conducteur 24. Les fils non conducteurs 24 sont de préférence thermo-fusibles ou thermoplastiques pour fondre sous l'effet de l'énergie thermique d'une thermo-compression ou énergie des ultrasons.

A cause de la présence des fils non conducteurs 19 et 24, selon l'invention, on applique l'outil (thermode) (T) sur la plage métallique 16 ce qui a pour effet de faire fondre le fil de fixation et/ou fil associés passant dessous et ce sans pollution de l'outil de soudage. De préférence, une enclume E vient supporter le fil d'antenne pendant la connexion.

Sur les figures 8 et 9, une autre configuration du dispositif est telle que la portion terminale du fil d'interconnexion 8b est disposée à l'aplomb de la plage mais sur la face du support 15 voire 2f (si le tissu est manipulable) opposée à celle portant la plage de contact 16. Dans ce cas l'enclume E très fine pousse le fil d'antenne contre la plage de contact à travers le support en faisant fluer le matériau 15 du support et/ou en écartant les mailles du support fibreux 2f associé ou non à un matériau de renfort 15.

A la figure 10, on voit un exemple de tissu 2F utilisable par l'invention et qui comporte des fils de chaine et de trame avec un maillage (m) lâche compris entre 200 µm et 300 µm) et composé de fils polyamide de 48 dtex. Le fil d'interconnexion 3 est fixé par broderie sur le tissu par le fil isolant 19.

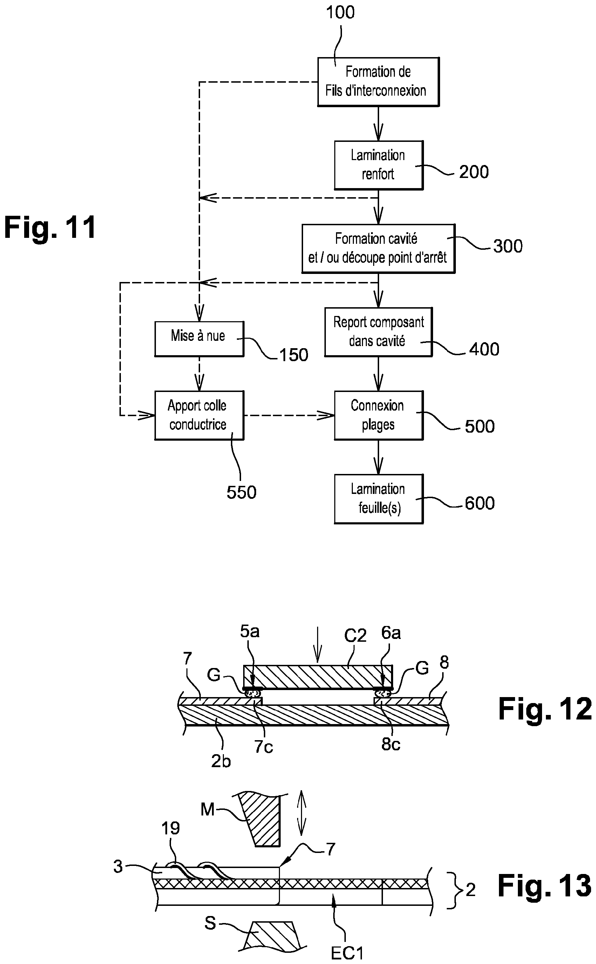

En référence à la figure 11, sera décrit maintenant un mode de mise en oeuvre préféré du procédé de l'invention permettant de satisfaire les objectifs, mais en présentant au préalable les difficultés rencontrées.

Pour la fabrication d'inserts bas coût comportant des fils d'interconnexion, les inventeurs ont sélectionné notamment des supports comportant des fils d'interconnexion par exemple cousues, brodés ou équivalents sur support comprenant des tissus.

En particulier, en broderie notamment pour des questions de productivité et facilité de mise en oeuvre, plusieurs antennes sont d'abord réalisées en même temps sur des bancs à broder de préférence sur un support textile, fibreux tel un tissu, tissé, non tissé, ou support accepté par les machines à broder ou à coudre. En production, on obtiendra un support avec de nombreux motifs de portions de fils conducteurs non connectées comme à la figure 2.

Cependant, ne sont pas exclus tout matériau apte à être cousu ou brodé comprenant par exemple d'autres substrats isolants tels que un film ou feuille en matériau polymère, en PVC, PET (polyéthylène), papier, polyimide, cuir synthétique notamment en composite fibre / tissu et feuille polymère.

Pour des questions de discrétion du dispositif, ultérieurement laminé ou ajouté à un objet, mais aussi de productivité et facilité de couture ou broderie, le support est un tissu très fin. Le substrat du dispositif au final, peut avoir différentes épaisseurs, généralement inférieures ou égales à celle d'une carte à puce de 0,76 mm de manière le cas échéant à servir d'insert entre deux films ou feuilles ou servir de support à une feuille de couverture et/ou d'impression. Typiquement le substrat peut avoir une épaisseur allant par exemple de 0,1 mm à 0,5 mm.

Les inventeurs ont noté une absence de stabilité dimensionnelle ou tenue de certains substrats notamment en tissu convenant à cette production en série notamment lorsqu'ils sont continus et en défilement. Ce manque de tenue rend difficile voire impossible un positionnement précis de composants électroniques, électriques, microcircuits ou des plages de contact ou des cavités notamment par indexation sur le substrat, avant où après la réalisation des fils d'interconnexion.

L'ajout d'une feuille ou matériau de renfort ou autre tissu au substrat, avec éventuellement des cavités de réception de modules préétablies tel qu'imaginé par les inventeurs, apporterait de la stabilité dimensionnelle au substrat mais présente aussi des inconvénients : du fait du manque de tenue du substrat et indexation difficile, les cavités risquent d'être mal positionnées.

Ajouter la feuille avant de réaliser les fils d'interconnexion, n'est pas favorable au rendement en broderie. A l'inverse, l'ajout de ce renfort, sans cavité, apporterait de la stabilité dimensionnelle au substrat, mais cela augmenterait la difficulté de connexion par ultrasons ou thermo-compression dans la mesure où il n'y aurait pas de cavité pour introduire une puce ou module et rapprocher les plages de contact des portions terminales et réaliser une bonne connexion.

Les inventeurs ont trouvé que les composants électroniques ou plages de contact doivent être de préférence reportés sur le substrat après réalisation des fils ou pistes d'interconnexion pour des raisons de facilité de couture ou broderie des fils d'interconnexion, cadence de production, difficulté de placement et de connexion du composant ou réaliser ainsi les fils d'interconnexion de manière économique.

En outre, le fil d'interconnexion pouvant être gainé d'un isolant notamment pour réaliser un pont isolant croisant les fils ou peut être associé à des fils ou fibres non conducteurs pour des raisons notamment de solidité, prévention de casse de fil ou de fixation sur le support. Dans ce cas, il peut se produire des souillures, pollution de l'outil de soudure lors de la connexion par soudure à ultrasons ou thermo compression puisque l'outil de soudure (thermode) est appliquée directement sur le fil, et se trouve mis au contact des matériaux polluants entourant le fil dans une configuration ou le composant est reporté à côté des portions ou en dessous.

En outre, comme les fils d'interconnexion reposent sur le substrat, et que les inventeurs ont choisi un report et connexion des plages effectuées par dessus l'antenne, cette dernière peut avoir tendance à enfoncer dans la feuille ou masse fibreuse ajoutée sous l'effet de la pression des moyens de soudure selon la nature des matériaux utilisés.

Après ces considérations, le procédé de la figure est élaboré comme ci-après.

A l'étape 100, (fig. 2), le procédé de réalisation d'un dispositif comportant au moins un fil d'interconnexion connecté à des plages de contact de composant ou pour composant comporte une étape de fourniture ou réalisation d'un fil avec des portions terminales de connexion reposant sur un substrat.

Le fil est réalisée de préférence par broderie ou couture sur un support souple comportant un tissu;

Le fil peut comporter au moins un revêtement isolant sur toute sa surface; Il peut aussi cumulativement ou alternativement être au contact de fils isolants par endroits. Le fil est fixé sur le substrat à l'aide d'un fil non conducteur, dit fil de canette ou fil complémentaire de broderie ou de couture.

De préférence, le fil est un fil hybride associé à au moins un fil non conducteur pour permettre notamment une meilleure cadence sans cassure du fil.

Ce fil non conducteur entoure au moins par endroit le fil d'antenne et constitue en quelque sorte un gainage isolant par endroit.

De préférence, le fil non conducteur est thermo fusible ou thermoplastique pour permettre leur retrait ou élimination au niveau de la zone de soudure.

Des fils non thermo fusibles peuvent convenir dès l'instant où l'énergie de la soudure est suffisante pour les éliminer, les dégrader (ou qu'une matière de brasure suffisante est ajoutée pour passer à travers).

Toutefois, d'autres techniques de fixation du fil conducteur sur un substrat peuvent être choisies parmi d'autres moins performantes comme l'incrustation.

La réalisation de l'antenne en broderie peut comprendre de préférence une étape de réalisation d'un point d'arrêt (non représenté) du fil d'interconnexion de couture, de broderie, tricotage en bout de l'une au moins des dites portions terminales et de préférence à l'intérieur de chaque emplacement en pointillé (EC1, EC2....) des composants (C1, C2...) à reporter; puis de préférence une étape d'élimination dudit point d'arrêt comprenant éventuellement une élimination de matière du support au moins en regard du point d'arrêt (PA) et formation éventuelle d'une cavité. La cavité peut correspondre soit à l'encombrement du composant de manière à l'encastrer dedans, soit uniquement à des zones du point d'arrêt dans le cas ou le composant n'est pas à encastrer.

Les portions terminales du fil d'interconnexion ou points d'arrêt peuvent être superposées ensemble ou réalisées dans une zone du support destinée à être éliminée. En cas d'élimination d'un point d'arrêt par poinçonnage, la portion terminale correspondante s'étend jusqu'au bord d'une cavité.

Selon une variante de réalisation, on prévoit un motif de fil continu comprenant au moins ou destiné à former après découpe, deux fils d'interconnexion, le procédé comprenant une étape de réalisation d'un motif comportant un fil continu et une étape ultérieure de découpe du motif pour former les deux fils d'interconnexion.

Comme indiqué précédemment, le support est de préférence un tissu très fin, mais d'autres supports fins sont envisageables

A l'étape 200 ensuite, selon une caractéristique, le procédé peut comporter une étape selon laquelle on dispose un matériau de renfort sous forme de feuille ou couche sur une face du substrat opposée à celle portant les portions terminales.

La couche ou feuille de renfort est disposée dans l'exemple directement après réalisation de l'antenne.

Comme déjà mentionné, un effet semblable à l'ajout d'une feuille peut être obtenu par imprégnation ou enduction d'une couche ou pulvérisation d'un produit tel un enduit, un apprêt, une résine, une mousse polymère, une gomme, apte à stabiliser dimensionnellement le substrat.

A l'étape 300, le support étant stabilisé, il est possible de le manipuler et d'effectuer des opérations plus classiques comme notamment reporter avec plus de facilité des plages de contact sur le substrat.

Cependant, il est préféré selon une autre caractéristique, de procéder à une étape de formation d'une cavité dans le substrat et/ou feuille ou couche de renfort à proximité des portions terminales de connexion de l'antenne de manière à introduire la puce ou module ou composant.

La cavité est réalisée par poinçonnage mais, on pourrait envisager un formage par pression ou emboutissage ou autre usinage au moins partiel du substrat.

A l'étape 400, les plages sont reportées de manière à présenter une surface en regard d'une portion terminale de connexion reposant sur le substrat ou en regard d'une portion pleine de substrat (sans cavité) L'invention se distingue donc de l'art antérieur dans lequel pour connecter une antenne, il est connu de faire survoler le fil d'antenne au dessus d'une cavité de réception de composant et plots de connexion. Les plots accèdent au fil en passant par la cavité.

Dans l'invention lorsqu'il y a découpe de fil avec le support, la portion terminale de fil s'arrête au bord de la cavité découpée. La plage de contact reportée est donc en regard ou à l'aplomb d'une portion terminale, celle ci-étant également en regard d'une portion de support et non d'une cavité. Le cas échéant, une puce peut être reportée notamment par puce retournée sur les plages ou face arrière sur le substrat ou sur une plage de contact pour une connexion classique par tout moyen connu, voire même de type à fil soudé.

La surface en regard et utilisé dans la description, correspond à une projection de la section longitudinale d'un fil d'interconnexion sur une plage de connexion 8b, soit un rectangle généralement large du diamètre du fil et long de la longueur de la plage parcouru en regard.

De préférence, les plages sont déjà connectées à un composant électronique tel une puce; Et le composant est inséré au moins en partie dans la cavité, les plages restant en dehors de la cavité en reposant sur les portions terminales ou extrémités terminales reposant elles-mêmes sur le support.

A l'étape 500, on effectue la connexion des plages aux portions terminales de l'antenne; La connexion peut être réalisée sous forme d'une soudure par apport d'énergie entre les plages et les portions terminales, l'énergie de soudure est appliquée directement sur les plages à l'aide d'une thermode pour une soudure de type thermo-compression ou d'une sonde à ultrasons pour une soudure à ultra-son.

Pour la soudure, on utilise de préférence une enclume qui vient exercer un appui contre l'enfoncement de la portion terminale de l'antenne dans le support. L'enclume est d'autant plus recommandée que le fil d'interconnexion a tendance à s'enfoncer dans le substrat de part la finesse du fil et/ou mollesse du substrat et/ou matériau de renfort.

L'enclume transperce au moins la feuille ou couche de renfort en regard de la portion terminale à connecter de manière que la portion à connecter soit supportée par l'enclume pendant la soudure. La section de l'enclume est rectangulaire ou carrée d'une section de l'ordre de 0,3 x 1 mm² à 1 x 5 mm².

L'invention s'applique notamment dès l'instant où on doit effectuer, en quelque sorte "en aveugle", une connexion de plage métallique directement sur une portion terminale de fil d'interconnexion également métallique et disposé sur un support moins dur que le métal, par soudure, avec ou sans apport de matière de brasure, l'inverse étant une opération classique. A priori, lors de la soudure, la pression que répercute une piste ou portion terminale sur son support est plus importante que celle répercutée par une plage du fait du rapport et de pression de surface. Ce qui dissuade l'homme de l'art d'opter pour une configuration de connexion inverse à la normale.

Concernant le composant sensible C1, C2, on procède de la manière suivante :
En alternative, le procédé comporte une étape 550 d'apport de la colle conductrice entre les portions terminales de connexion et les contacts de composants; cette étape peut être réalisée directement après réalisation des fils d'interconnexion.

Sur la fig. 12, les portions terminales 7c, 8c appartiennent à un fil d'interconnexion non gainé ou dénudé et un composant C2, C2 est reporté et connecté via cette colle directement après la réalisation des pistes.

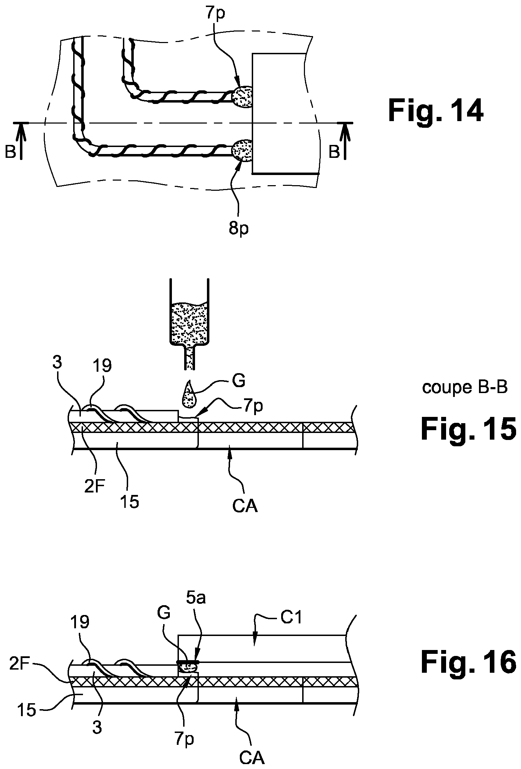

A l'étape 150 et sur les figures 13, 14, la portion terminale 7 étant gainée d'isolant, le procédé comporte une étape de mise à nu préalablement ou au cours de la connexion (par exemple par fusion). La mise à nu (pour enlever l'émail ou gainage isolant) peut s'effectuer de différentes manières. En particulier, par le biais d'un aplatissement de la portion terminale préalablement à la connexion à l'aide de différents moyens connus. Pour cela, on peut utiliser tout moyen utilisant la pression, la température, les ultrasons.

Ici, on utilise un marteau vibrant M et un appui S.

On obtient par conséquent une des portions terminales de connexion 7p, 8p aplaties (illustrées sur le figure 14 en vue de dessus de la figure 13).

A la figure 15, un adhésif conducteur G, tel une goutte, est apporté entre la portion terminale (7b, 8b) et le contact (5, 6) d'un composant ou contact destiné à connecter un composant.

A la figure 16 un composant, par exemple C2 est reporté et connecté via la colle conductrice G aux portions terminales 7p, 8p. Ici le composant n'est pas encastré mais une cavité CA d'élimination de points d'arrêt est prévue. Le fil d'interconnexion s'arrête donc au bord de la cavité puisqu'il a été sectionné par poinçonnage notamment, en même temps que le substrat 2f et renfort 15.

A l'étape 600, on assemble le support avec au moins une feuille sur le côté opposé à la feuille de renfort. Les feuilles peuvent par exemple être constituées en matériaux utilisés pour les feuilles ou couverture de passeport ou carte à puce ou autre objet. On procède ensuite à des découpes au format. Le cas échéant, la découpe peut s'effectuer à d'autres étapes.

Dans le cas où on utilise des fils conducteurs comme fil de chaîne ou trame, selon le mode III de la figure 3, on prévoit de réaliser des parcours à angle droits. Des connections de fils aux intersections chaine / trame conductrice sont nécessaires et réalisables par tout moyen connu comme la thermo compression ou selon l'invention par aplatissement aux intersections puis connexion par colle conductrice.

Le procédé de l'invention comprend donc dans un mode préféré de mise en oeuvre, très rapide et simple, la formation d'une pluralité de motifs continus de piste ou de fil conducteur destinés à former après découpe des fils d'interconnexion sur un support de grande dimension, de préférence, par broderie ou couture, le support étant découpé ultérieurement pour former des supports élémentaires comportant un motif.

Les motifs d'une rangée peuvent être reliés entre eux par le même fil;
Le procédé comporte de préférence l'adjonction d'un matériau de renfort au support;
Une opération de découpe des fils et de formation de cavités intervient ensuite;
Puis le cas échéant, avec le même outil ou au même poste, intervient l'aplatissement des extrémités terminales de chaque fil d'interconnexion pour dénuder les portions de connexion, qui peut se faire aussi avant découpe du fil ou séparation des fils d'interconnexion;
Chaque support élémentaire est individualisé par découpe et est prêt à alimenter d'autres postes de report et d'interconnexion de composants.

Les composants sont connectés en étant placés de préférence dans les cavités.

## Revendications

1. Procédé de réalisation d'un dispositif comportant au moins deux composants distincts interconnectés sur un substrat par au moins un fil d'interconnexion,
ledit procédé comprenant les étapes suivantes:
- réalisation du fil d'interconnexion (3) par dépôt de fil individuel continu par technique filaire sur le substrat (2, 2f, 2b) selon un motif d'interconnexion prédéfini, ledit fil comportant au moins une portion terminale (7, 8) de connexion exposée sur le substrat;
- report d'au moins un contact (5, 6) d'un des composants (C1, C3) en regard de la portion terminale (7b, 8b) et connexion du contact à cette portion terminale.

2. Procédé selon la revendication 1, **caractérisé en ce que** la portion terminale étant gainée d'isolant, le procédé comporte une étape de mise à nu préalablement ou au cours de la connexion.

3. Procédé selon la revendication 2, **caractérisé en ce que** la mise à nu s'effectue par un aplatissement (7p, 8p) de la portion terminale préalablement à la connexion.

4. Procédé selon l'une des revendications 1 à 3, **caractérisé en ce que** la connexion est réalisée par un adhésif conducteur (G) apporté entre la portion terminale (7c, 7p, 8c, 8p) et le contact (5, 5a, 6, 6a) .

5. Procédé selon la revendication 1 ou 2, **caractérisé en ce que** la connexion est réalisée par une soudure (38) de type thermo-compression ou à ultrasons.

6. Procédé selon l'une des revendications précédentes, **caractérisé en ce que** le fil d'interconnexion est réalisé par broderie ou couture sur un substrat souple (2f) comportant un tissu et **en ce qu'**il comprend une étape selon laquelle on dispose un matériau de renfort (15) sous forme de feuille ou couche sur une face (36) du substrat opposée à celle (34) portant les portions terminales.

7. Procédé selon la revendication 6, **caractérisé en ce que** la couche ou feuille de renfort est disposée après réalisation du fil d'interconnexion.

8. Procédé selon la revendication précédente, **caractérisé en ce que** le procédé comprend une étape de formation d'une cavité (26) dans le substrat et/ou feuille ou couche de renfort à proximité des portions terminales (7b, 8b).

9. Procédé selon la revendication 5, **caractérisé en ce que** la soudure utilise une enclume (E) qui vient exercer un appui contre l'enfoncement de la portion terminale et **en ce que** l'enclume transperce, d'un trou (17) au moins, la feuille ou couche de renfort (15) en regard de la portion terminale à connecter de manière que la portion (7b, 8b) à connecter soit supportée par l'enclume pendant la soudure.

10. Procédé selon l'une quelconque des revendications précédente, **caractérisé en ce que** le fil d'interconnexion est un fil hybride (22) associé à au moins un fil non conducteur.

11. Procédé selon l'une quelconque des revendications précédente, **caractérisé en ce que** pour réaliser au moins deux fils d'interconnexion, le procédé comprend une étape de réalisation d'un motif comportant un fil continu et une étape ultérieure de découpe du motif pour former au moins les deux fils d'interconnexion.

12. Dispositif comportant :
- au moins deux composants distincts sur un substrat, interconnectés par au moins une piste d'interconnexion, la piste d'interconnexion (3) étant réalisé par dépôt d'un fil d'interconnexion continu par technique filaire sur le substrat (2, 2f, 2b), ledit fil comportant au moins une portion terminale (7, 8) de connexion exposée sur le substrat dans la zone de connexion,
- au moins un contact (5, 6) d'un des composants (C1, C3) étant reporté en regard de la portion terminale (7b, 8b) et connecté à cette portion terminale.

13. Dispositif selon la revendication 12, **caractérisé en ce que** le fil étant gainé d'isolant, la portion terminale est mise à nu au niveau de la connexion.

## Patentansprüche

1. Verfahren zur Herstellung einer Vorrichtung bestehend aus mindestens zwei getrennten Komponenten, die auf einem Trägermaterial mithilfe eines Verbindungskabels miteinander verbunden sind, wobei das Verfahren die folgenden Schritte umfasst:
- Herstellung eines Verbindungskabels (3) durch Verlegung eines kontinuierlichen Einzeldrahtes mittels Drahttechnik auf dem Trägermaterial (2, 2f, 2b) gemäß einem vorgegebenen Verbindungsmuster, wobei der Draht mindestens einen Anschluss-Endabschnitt (7, 8) umfasst, der auf dem Trägermaterial liegt;
- Verschiebung mindestens eines Kontakts (5, 6) eines der Komponenten (C1, C3) gegenüber dem Endabschnitt (7b, 8b) und Anschluss des Kontakts an diesen Endabschnitt.

2. Verfahren nach Anspruch 1, **dadurch gekennzeichnet, dass** der Endabschnitt mit einer Isolierung ummantelt ist, wobei das Verfahren einen Schritt umfasst, bei der das Kabel vor oder bei seinem dem Anschluss abisoliert wird.

3. Verfahren nach Anspruch 2, **dadurch gekennzeichnet, dass** die Abisolierung durch Flachdrücken (7p, 8p) des Endabschnitts vor dem Anschluss erfolgt.

4. Verfahren nach einem der Ansprüche 1 bis 3, **dadurch gekennzeichnet, dass** der Anschluss mittels eines leitfähigen Haftklebers (G) erfolgt, der zwischen dem Endabschnitt (7c, 7p, 8c, 8p) und dem Kontakt (5, 5a, 6, 6a) aufgebracht wird.

5. Verfahren nach einem der Ansprüche 1 oder 2, **dadurch gekennzeichnet, dass** der Anschluss mittels eines Schweißverfahrens (38) vom Typ Thermokompressionsschweißen oder Ultraschall-Schweißen erfolgt.

6. Verfahren nach einem der vorhergehenden Ansprüche, **dadurch gekennzeichnet, dass** das Verbindungskabel mittels Übersticken oder Übernähen auf einem flexiblen Trägermaterial (2f) hergestellt wird, welches ein textiles Gewebe umfasst, und **dadurch gekennzeichnet, dass** es einen Schritt umfasst, bei dem auf einer Seite (36) des Trägermaterials gegenüber der Seite (34) mit den Endabschnitten ein Verstärkungsmaterial (15) in Form einer Folie oder Schicht aufgebracht wird.

7. Verfahren nach Anspruch 6, **dadurch gekennzeichnet, dass** die Verstärkungsschicht bzw. Verstärkungsfolie nach der Herstellung des Verbindungskabels aufgebracht wird.

8. Verfahren nach vorhergehendem Anspruch, **dadurch gekennzeichnet, dass** das Verfahren einen Schritt zur Bildung eines Hohlraums (26) im Trägermaterial und/oder in der Verstärkungsschicht in der Nähe der Endabschnitte (7b, 8b) umfasst.

9. Verfahren nach Anspruch 5, **dadurch gekennzeichnet, dass** zum Schweißen ein Amboss (E) verwendet wird, der einen Druck gegen die Einsenkung des Endabschnitts ausübt und dass der Amboss mindestens ein Loch (17) in die Verstärkungsschicht bzw. Verstärkungsfolie (15) gegenüber dem anzuschließenden Endabschnitt bohrt, sodass der anzuschließende Abschnitt (7b, 8b) während des Schweißens durch den Amboss gestützt wird.

10. Verfahren nach einem der vorhergehenden Ansprüche, **dadurch gekennzeichnet, dass** das Verbindungskabel ein Hybridkabel (22) ist, das mit mindestens einem nicht leitfähigen Draht verbunden ist.

11. Verfahren nach einem der vorhergehenden Ansprüche, **dadurch gekennzeichnet, dass** dieses Verfahren zur Herstellung von mindestens zwei Verbindungskabeln einen Schritt der Herstellung eines Musters umfasst, das einen kontinuierlichen Draht umfasst, und einen darauffolgenden Schritt des Ausschneidens des Musters umfasst, um mindestens zwei Verbindungskabel herzustellen.

12. Vorrichtung umfassend:
- mindestens zwei getrennte Komponenten auf einem Trägermaterial, die über mindestens eine Verbindungsspur miteinander verbunden sind.
die Verbindungsspur (3), die durch Verlegung eines kontinuierlichen Drahtes mittels Drahttechnik auf dem Trägermaterial (2, 2f, 2b) hergestellt wird, wobei der Draht mindestens einen Anschluss-Endabschnitt (7, 8) umfasst, der im Verbindungsbereich auf dem Trägermaterial liegt,
- mindestens einen Kontakt (5, 6) eines der Komponenten (C1, C3), der gegenüber dem Endabschnitt (7b, 8b) verschoben und an diesen Endabschnitt angeschlossen wird.

13. Vorrichtung nach Anspruch 12, **dadurch gekennzeichnet, dass** der Draht mit einer Isolierung ummantelt ist, wobei der Endabschnitt auf Höhe des Anschlusses abisoliert wird.

## Claims

1. A method for making a device comprising at least two distinct components interconnected on a substrate by at least one interconnecting wire, where said method comprises the following steps:
- making the interconnecting wire (3) by depositing a continuous individual wire using the wire bonding technique on the substrate (2, 2f, 2b) using a predefined interconnection pattern, where said wire comprises at least one terminal connecting portion (7, 8) exposed on the substrate;
- placement of at least one contact (5, 6) of one of the components (C1, C3) opposite the terminal portion (7b, 8b) and connection of the contact to this terminal portion.

2. A method according to claim 1, **characterised in that** the terminal portion has an insulating sleeve, where the method comprises a stripping step prior to or during the connection process.

3. A method according to claim 2, **characterised in that** stripping is achieved by flattening (7p, 8p) the terminal portion prior to the connection process.

4. A method according to any of claims 1 to 3, **characterised in that** the connection is made by conductive adhesive (G) applied between the terminal portion (7c, 7p, 8c, 8p) and the contact (5, 5a, 6, 6a).

5. A method according to claim 1 or 2, **characterised in that** the connection is made by bonding (38) of the thermocompression or ultrasonic type.

6. A method according to any of the foregoing claims, **characterised in that** the interconnecting wire is embroidered or sewn on a flexible substrate (2f) comprising fabric and **in that** it comprises a step where reinforcing material (15) is deposited in the form of a film or coat on a side (36) of the substrate opposite that (34) bearing the terminal portions.

7. A method according to claim 6, **characterised in that** the reinforcing coat or film is placed after the interconnecting wire is made.

8. A method according to the foregoing claim, **characterised in that** the method comprises a step for the formation of a cavity (26) in the substrate and/or the reinforcing film or coat near the terminal portions (7b, 8b).

9. A method according to claim 5, **characterised in that** soldering uses an anvil (E) that presses against the indentation of the terminal portion and **in that** the anvil pierces the reinforcing film or coat (15) opposite the terminal portion to connect through at least one hole (17), so that the portion (7b, 8b) to connect is supported by the anvil during bonding.

10. A method according to any of the foregoing claims, **characterised in that** the interconnecting wire is a hybrid wire (22) associated with at least one non-conductive wire.

11. A method according to any of the foregoing claims, **characterised in that** to make at least two interconnecting wires, the method comprises a step for making a pattern comprising a continuous wire and a subsequent step for cutting the pattern to form at least the two interconnecting wires.

12. A device comprising:
- at least two distinct components on a substrate, interconnected by at least one interconnecting trace,
the interconnecting trace (3) is made by depositing a continuous interconnecting wire using the wire bonding technique on the substrate (2, 2f, 2b) where said wire comprises at least one terminal connection portion (7, 8) exposed on the substrate in the connection area,
- where at least one contact (5, 6) of one of the components (C1, C3) is placed opposite the terminal portion (7b, 8b) and connected to that terminal portion.

13. A device according to claim 12, **characterised in that** the wire has an insulating sleeve, where the terminal portion is stripped at the connection.
